# EUROPÄISCHE PATENTSCHRIFT

(11) **EP 2 992 376 B1**
(45) Veröffentlichungstag und Bekanntmachung des Hinweises auf die Patenterteilung: **07.10.2020**
(21) Anmeldenummer: 14745069.6
(22) Anmeldetag: 29.04.2014
(51) Int. Cl.: G02B 6/42, H05K 1/18, H05K 1/02, H05K 1/11

(54) **VORRICHTUNG ZUM EINKOPPELN UND/ODER AUSKOPPELN OPTISCHER SIGNALE**
DEVICE FOR INCOUPLING AND/OR OUTCOUPLING OPTICAL SIGNALS
DISPOSITIF D'INJECTION ET/OU DE PRÉLÈVEMENT DE SIGNAUX OPTIQUES

(30) Priorität: 29.04.2013 DE 102013104367; 08.05.2013 DE 102013104787
(43) Veröffentlichungstag der Anmeldung: 09.03.2016
(73) Patentinhaber: Silicon Line GmbH, 80687 München (DE)
(72) Erfinder: HOELTKE, Holger, 80995 München (DE); GROEPL, Martin, 87527 Sonthofen Oberallgaeu (DE)
(74) Vertreter: Hofmann, Andreas
(86) Internationale Anmeldenummer: PCT/DE2014/200187
(87) Internationale Veröffentlichungsnummer: WO 2014/177148

(56) Entgegenhaltungen:
- US-A- 5 937 125
- US-A1- 2001 010 744
- US-A1- 2010 215 312
- US-A1- 2012 121 272
- US-B1- 6 222 665

## Beschreibung

### Technisches Gebiet

Die vorliegende Erfindung betrifft eine Vorrichtung zum Einkoppeln optischer Signale in mindestens einen Wellenleiter gemäß dem Oberbegriff des Anspruchs 1.

Die vorliegende Erfindung betrifft des Weiteren eine komplementäre Vorrichtung zum Auskoppeln optischer Signale aus mindestens einem Wellenleiter gemäß dem Oberbegriff des Anspruchs 2.

### Stand der Technik, insbesondere dessen Nachteile und technische Probleme

Vertical Cavity Surface Emitting Lasers (VCSEL) bzw. Fotodioden (PD) senden bzw. empfangen als optische Wandler, insbesondere als aktiv-optische Wandler, optische Signale im Wesentlichen senkrecht zu ihrer Oberfläche.

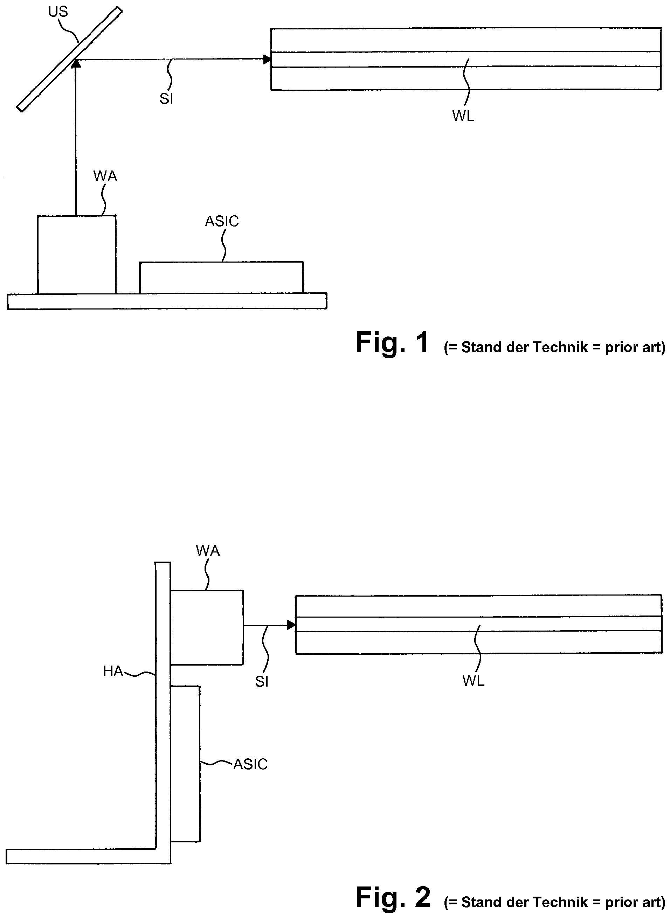

Um derartige optischen Signale SI in einen optischen Wellenleiter WL einzukoppeln bzw. aus einem optischen Wellenleiter WL auszukoppeln, sind die optischen Signale SI über einen 45 Grad-Umlenkspiegel US aus der Sende- bzw. Empfangsrichtung des optischen Wandlers WA in eine um neunzig Grad versetzte Ebene des Wellenleiters WL umzulenken, wie Fig. 1 entnehmbar.

So beschreibt die Druckschrift DE 10 2012 005 618 A1 ein aktives optisches Kabel, dessen Fasern stoffschlüssig an einem optischen Substrat befestigt sind. Die Fasern koppeln hierbei an einen integrierten optischen Wellenleiter. Ein Umlenkelement leitet den Freistrahl zur auf der Oberfläche des Substrats angeordneten Prozesseinheit, wobei der Freistrahl eine Richtungsänderung von neunzig Grad erfährt, um den Freistrahl in eine Sende-/Empfangseinheit zu lenken.

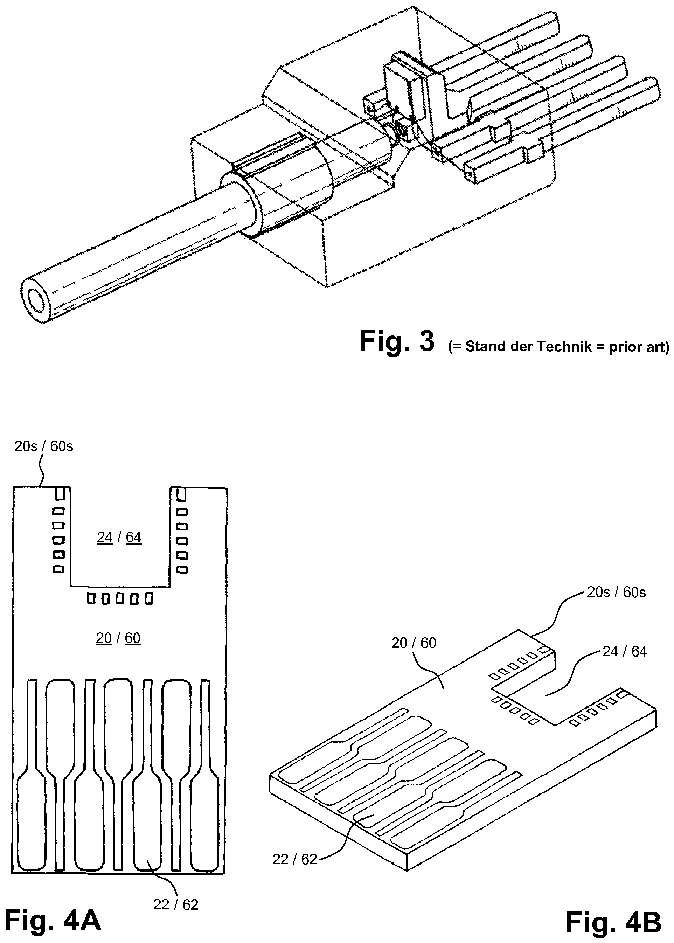

Alternativ lassen sich optische Wandler WA mittels einer entsprechenden Halterung HA so anordnen, dass ihre Sende- bzw. Empfangsrichtung der Ebene des Wellenleiters WL entspricht, wie Fig. 2 und Fig. 3 entnehmbar.

Nachteilig ist bei aus dem Stand der Technik bekannten Lösungen (vgl. US 6 222 665 B1, US 2012/0121272 A1, US 2001/0010744 A1) die Baugröße der Ein- und Auskoppelvorrichtungen. Aufgrund dieser Baugröße eignen sich die bekannten Lösungen nicht zur Realisierung von Applikationen im Heim- und Mobilelektronikbereich. Dies impliziert längere Verbindungswege zwischen den Bauteilen und folglich längere Latenzzeiten.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Stands der Technik liegt der vorliegenden Erfindung die Aufgabe zugrunde, eine Vorrichtung gemäß dem Oberbegriff des Anspruchs 1 sowie eine Vorrichtung gemäß dem Oberbegriff des Anspruchs 2 so weiterzubilden, dass eine entsprechende Miniaturisierung der Ein- und Auskoppelvorrichtung bei geringen optischen Verlusten ermöglicht wird; gleichzeitig soll der Aufwand in der Herstellung gering sein.

Diese Aufgabe wird durch eine Vorrichtung mit den Merkmalen des Anspruchs 1 sowie durch eine Vorrichtung mit den Merkmalen des Anspruchs 2 gelöst, insbesondere durch eine miniaturisierte aktiv-optische Sendeeinheit und/oder durch eine miniaturisierte aktiv-optische Empfangseinheit. Vorteilhafte Ausgestaltungen und zweckmäßige Weiterbildungen der vorliegenden Erfindung sind in den jeweiligen Unteransprüchen gekennzeichnet.

Erfindungsgemäß werden über elektrische Anschlusskontakte eingehende elektrische Signale in mindestens einem Schaltkreis verarbeitet. Der Schaltkreis, der als anwendungsspezifische integrierte Schaltung oder als Application-Specific Integrated Circuit (ASIC), zum Beispiel als custom chip, ausgeführt sein kann kann, steuert mindestens einen elektro-optischen Wandler, insbesondere mindestens einen Laser, zum Beispiel mindestens einen Vertical Cavity Surface Emitting Lasers (VCSEL), an, der die optischen Signale axial zum Wellenleiter aussendet und in diesen Wellenleiter, zum Beispiel in mindestens eine Glasfaser, einkoppelt.

Der sendeseitige Schaltkreis, der elektro-optische Wandler und die sendeseitigen Anschlusskontakte sind hierbei so angeordnet, dass sie sich im Wesentlichen in einer Ebene befinden. Die flache Bauweise ermöglicht, im Gegensatz zu konventionellen Lösungsansätzen, eine Reduktion der Bauhöhe. Die Fertigung eines ebenen Substratmediums ist auch unter produktions- und kostentechnischen Gesichtspunkten vorteilhaft.

Das Substrat fungiert in erster Linie als Aufnahmemedium für den sendeseitigen Schaltkreis sowie für die sendeseitigen Anschlusskontakte und verfügt über Kommunikationsschnittstellen und elektrische Verbindungen, um die Kommunikation der einzelnen Komponenten miteinander zu ermöglichen.

Empfangsseitig werden die eingehenden optischen Signale durch mindestens einen opto-elektrischen Wandler aus Richtung der Achse des Wellenleiters, insbesondere mindestens einer Glasfaser, ausgekoppelt. Dieser opto-elektrische Wandler, der eine Diode, insbesondere eine Fotodiode, sein kann, wandelt die optischen Signale in elektrische Signale um und gibt diese an mindestens einen Schaltkreis, insbesondere an mindestens eine anwendungsspezifische integrierte Schaltung oder an mindestens einen Application-Specific Integrated Circuit (ASIC), zum Beispiel an mindestens einen custom chip, aus. Im Schaltkreis werden die Signale verarbeitet, gegebenenfalls verstärkt und an Anschlusskontakte ausgegeben.

Der empfangsseitige Schaltkreis, der opto-elektrische Wandler und die empfangsseitigen Anschlusskontakte sind hierbei so angeordnet, dass sie sich im Wesentlichen in einer Ebene befinden. Die flache Bauweise ermöglicht, im Gegensatz zu konventionellen Lösungsansätzen, eine Reduktion der Bauhöhe. Die Fertigung eines ebenen Substratmediums ist auch unter produktions- und kostentechnischen Gesichtspunkten vorteilhaft.

Das Substrat fungiert in erster Linie als Aufnahmemedium für den sendeseitigen Schaltkreis sowie für die sendeseitigen Anschlusskontakte und verfügt über Kommunikationsschnittstellen und elektrische Verbindungen, um die Kommunikation der einzelnen Komponenten miteinander zu ermöglichen.

Gemäß der vorliegenden Erfindung weist das Substrat eine Aussparung auf, wobei die Abmessungen dieser Aussparung den Abmessungen des sende- bzw. empfangsseitigen Schaltkreises entsprechen. Dies hat den Vorteil, dass der Schaltkreis in das Substrat eingepasst werden kann und direkt mit den Leitungen in Kontakt steht, die im Substrat eingebettet sind.

Gemäß der vorliegenden Erfindung ist die Aussparung so gestaltet, dass sie zur von den Anschlusskontakten abgewandten Stirnseite hin offen ist. Hierbei ist die Aussparung so definiert, dass der Schaltkreis bündig mit der Stirnfläche abschließt. Dies ist besonders aus fertigungs- und kostentechnischen Gründen interessant.

Gemäß der vorliegenden Erfindung ist die Höhe des Substrats im Wesentlichen gleich der Höhe des Schaltkreises, um den Schaltkreis komplett im Substrat einzubetten und auf diese Weise vor äußeren Einwirkungen besser schützen zu können.

Nach einer vorteilhaften Weiterbildung der vorliegenden Erfindung kann der Wandler auf der Stirnfläche montiert, insbesondere geklebt, werden, ohne dass der Wandler bündig mit der Stirnseite des Substrats und/oder des Schaltkreises abschließt. Diese Variante ermöglicht eine hohe Flexibilität in der Produktion.

Gemäß der vorliegenden Erfindung ist mindestens eine Bondfläche an der Stirnseite des Substrats und/oder des Schaltkreises angebracht. Die Bondflächen ermöglichen eine Stromversorgung für den Wandler und schließen insbesondere bündig mit dem Substrat und/oder mit dem Schaltkreis ab.

Gemäß einer vorteilhaften Weiterbildung der vorliegenden Erfindung ist es nützlich, die Vorrichtung mit einem schützenden Gehäuse zu versehen, insbesondere für den Gebrauch als steckbares aktives optisches Kabel. Zusätzlich kann das Gehäuse die Funktion übernehmen, den optischen Wellenleiter und die Vorrichtung mechanisch zu fixieren.

Gemäß einer vorteilhaften Ausführungsform der vorliegenden Erfindung können/kann das Gehäuse und/oder die Vorrichtung mit mindestens einer Führung für den Wellenleiter ausgestattet sein, um die Montage, Positionierung und Fixierung des Wellenleiters an der Vorrichtung zu erleichtern.

Die vorgeschlagene Vorrichtung zum Einkoppeln bzw. Auskoppeln optischer Signale lässt sich in vielen Anwendungsbereichen gewinnbringend einsetzen, in erster Linie zur schnellen Signalübertragung zwischen zwei Komponenten mit elektrischer Signalführung.

So betrifft die vorliegende Erfindung vor allem die Verwendung zum Aufbau von, insbesondere steckbaren, aktiven optischen Kabeln zur schnellen und verlustarmen Signalumwandlung sowie Datenübertragung auf sehr kleinem Raum, um die elektrisch prozessierten Daten schnell an die verschiedenen Einheiten weiterzuleiten. Die extrem kurzen Leitungswege innerhalb der Vorrichtung ermöglichen sehr kurze Latenzzeiten.

Ebenso denkbar ist die Verwendung als steckbares aktives optisches Kabel, um Peripheriegeräte anzuschließen, wobei das Kabel in den Steckerenden die Signalverarbeitung, Signalwandlung und Ein- bzw. Auskopplung der Eingangs- bzw. Ausgangsignale vornimmt. Hierbei können auch bidirektionale Kabel, insbesondere wenn Sende- und Empfangsvorrichtung einem einzigen Substrat zugeordnet sind, oder laufrichtungsunabhängige Kabel, wenn der elektro-optische Wandler zugleich auch ein opto-elektrischer Wandler ist, zur Verfügung gestellt werden.

Darüber hinaus lässt sich ein neuartiger Aufbau eines miniaturisierten elektro-optischen Senders und/oder eines miniaturisierten opto-elektrischen Empfängers mit festverbundenem optischem Wellenleiter zur Übertragung von elektrischen Signalen über einen solchen optischen Wellenleiter mit dieser Vorrichtung realisieren.

Die vorliegende Erfindung zeichnet sich durch einen hohen Miniaturisierungsgrad aus, der auf die erfindungsgemäße Art der Positionierung und Integrierung der Komponenten zurückzuführen ist. Dies ermöglicht den Aufbau von A[ctive]O[ptical]C[able]s mit miniaturisierten elektro-optischen Sendern und/oder opto-elektrischen Empfängern.

Durch das "Versenken" bzw. Einbetten des Schaltkreises bzw. des Wandlers, insbesondere des elektro-optischen Senders und/oder des opto-elektrischen Empfängers, in der Substratebene bzw. in das Substrat lassen sich sehr kurze Signalverbindungslängen, zum Beispiel Bonddrahtlängen, erzielen, was insbesondere bei sehr hohen Datenübertragungsraten zum Erhalt der Signalqualität beiträgt und die Latenzzeiten reduziert.

Im Vergleich zu konventionellen Lösungen weist die vorliegende Erfindung geringere optische Verlustwerte auf, denn auf Umlenkelemente, Grenzflächen und Freistrahle kann verzichtet werden.

### Kurze Beschreibung der Zeichnungen

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die den Ansprüchen 1 und 2 nachgeordneten Ansprüche verwiesen, andererseits werden weitere Ausgestaltungen, Merkmale und Vorteile der vorliegenden Erfindung nachstehend unter anderem anhand des durch Fig. 4A bis Fig. 7 veranschaulichten Ausführungsbeispiels näher erläutert.

Es zeigt:
- Fig. 1: in konzeptuell-schematischer Darstellung eine Vorrichtung aus dem Stand der Technik, mittels derer optische Signale unter einem Winkel von neunzig Grad zur Emissionsrichtung einkoppelbar sind;
- Fig. 2: in konzeptuell-schematischer Darstellung eine Vorrichtung aus dem Stand der Technik, mittels derer optische Signale mittels einer L-Halterung in zum Wellenleiter axialer Richtung einkoppelbar sind;
- Fig. 3: in perspektivischer Darstellung ein Beispiel für die Realisierung einer Ein- bzw. Auskoppelvorrichtung aus dem Stand der Technik;
- Fig. 4A: in Aufsicht ein Ausführungsbeispiel für ein Trägersubstrat gemäß der vorliegenden Erfindung;
- Fig. 4B: in perspektivischer Darstellung das Trägersubstrat aus Fig. 4A;
- Fig. 5: in perspektivischer Darstellung ein Ausführungsbeispiel für eine mit dem Trägersubstrat aus Fig. 4A und Fig. 4B gebildete Vorrichtung gemäß der vorliegenden Erfindung;
- Fig. 6: in perspektivischer Darstellung die Vorrichtung aus Fig. 5 mit zugeordnetem optischem Wellenleiter;
- Fig. 7: in konzeptuell-schematischer Seitenansicht eine Vorrichtung gemäß der vorliegenden Erfindung, die über ein Gehäuse mit dem Wellenleiter aus Fig. 6 in Verbindung gebracht wird;
- Fig. 8: in perspektivischer Darstellung ein das Verständnis der vorliegenden Erfindung erleichterndes Beispiel für eine Vorrichtung;
- Fig. 9: in perspektivischer Darstellung ein weiteres das Verständnis der vorliegenden Erfindung erleichterndes Beispiel für eine Vorrichtung; und
- Fig. 10: in perspektivischer Darstellung ein weiteres das Verständnis der vorliegenden Erfindung erleichterndes Beispiel für eine Vorrichtung.

Gleiche oder ähnliche Ausgestaltungen, Elemente oder Merkmale sind in Fig. 4A bis Fig. 10 mit identischen Bezugszeichen versehen. Hinsichtlich der Sendeseite und der Empfangsseite wird zeichnerisch nicht unterschieden, jedoch weisen die den sendeseitigen Elementen entsprechenden empfangsseitigen Elemente ein um 40 höheres Bezugszeichen auf.

### Bester Weg zur Ausführung der vorliegenden Erfindung

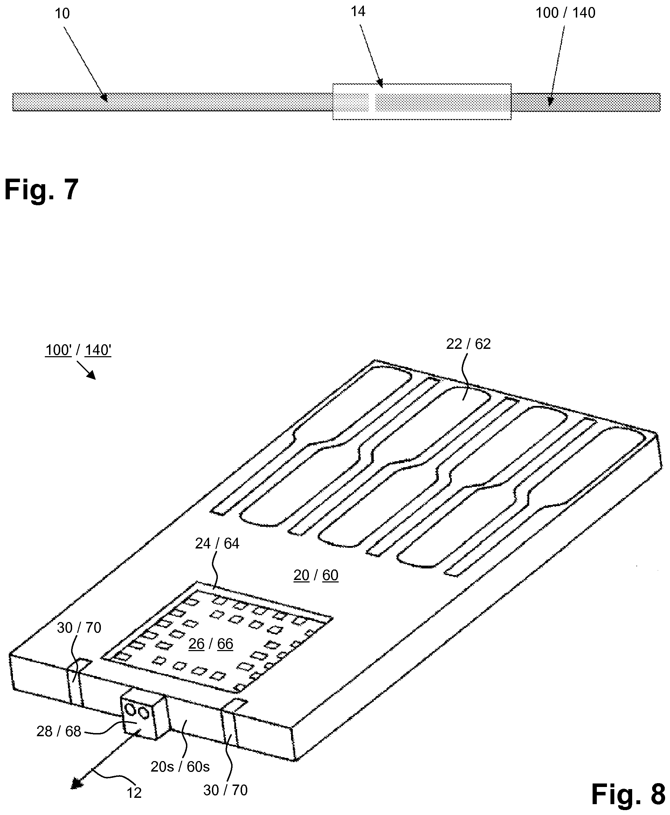

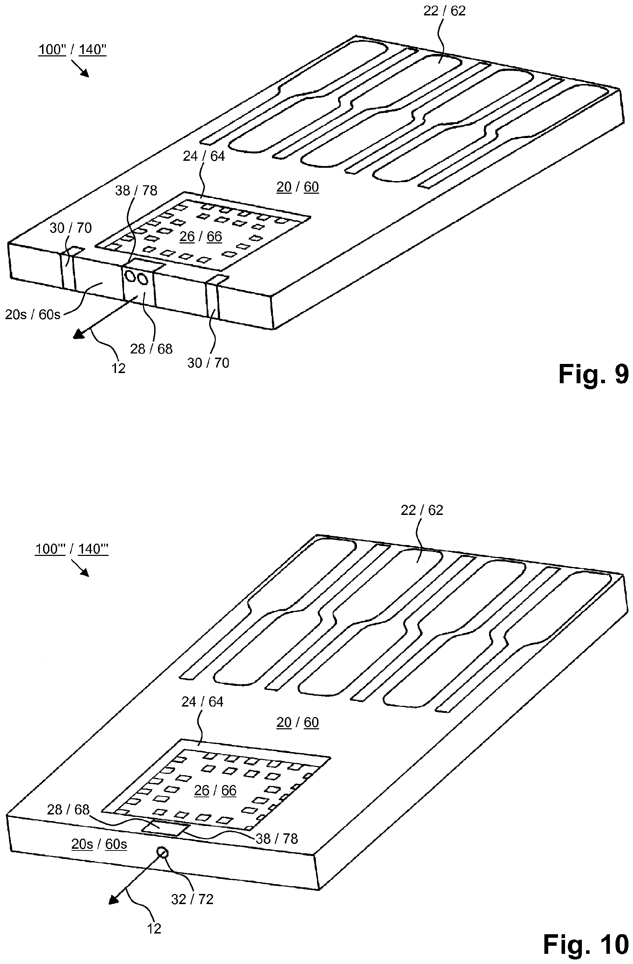

Zur Vermeidung überflüssiger Wiederholungen beziehen sich die nachfolgenden Erläuterungen hinsichtlich der Ausgestaltungen, Merkmale und Vorteile - soweit nicht anderweitig angegeben -
- sowohl auf das Ausführungsbeispiel einer erfindungsgemäßen Vorrichtung 100 bzw. 140 gemäß Fig. 4A bis Fig. 7
- als auch auf das das Verständnis der vorliegenden Erfindung erleichternde Beispiel einer Vorrichtung 100' bzw. 140' gemäß Fig. 8
- als auch auf das weitere das Verständnis der vorliegenden Erfindung erleichternde Beispiel einer Vorrichtung 100" bzw. 140" gemäß Fig. 9
- als auch auf das weitere das Verständnis der vorliegenden Erfindung erleichternde Beispiel einer Vorrichtung 100'" bzw. 140'" gemäß Fig. 10.

Erfindungsgemäß wird ein sendeseitiges Substrat 20 bzw. ein empfangsseitiges Substrat 60 bereitgestellt. Die Anschlusskontakte 22 bzw. 62, die insbesondere metallische Druckkontakte oder Schleifkontakte sein können, sind auf dem Substrat 20 bzw. 60 geträgert, wobei diese auch im Substrat eingearbeitet, zum Beispiel eingegossen, sein können.

Das Substrat 20 bzw. 60 weist in Fig. 4A und in Fig. 4B eine Aussparung 24 bzw. 64 auf, die in etwa der Dimensionierung eines ASIC 26 bzw. 66 (= Application-Specific Integrated Circuit oder anwendungsspezifische integrierte Schaltung, auch als custom chip bezeichnet) entspricht. Der ASIC 26 bzw. 66 wird im elektro-optischen Wandler 28 bzw. im opto-elektrischen Wandler 68 zur jeweiligen Signalverarbeitung benötigt.

In der Aussparung 24 bzw. 64 ist ein entsprechender Schaltkreis 26 bzw. 66 integriert, vorzugsweise geklebt oder gesteckt, wobei die Höhe des Substrats 20 bzw. 60 in etwa der Höhe des Schaltkreises 26 bzw. 66 entspricht.

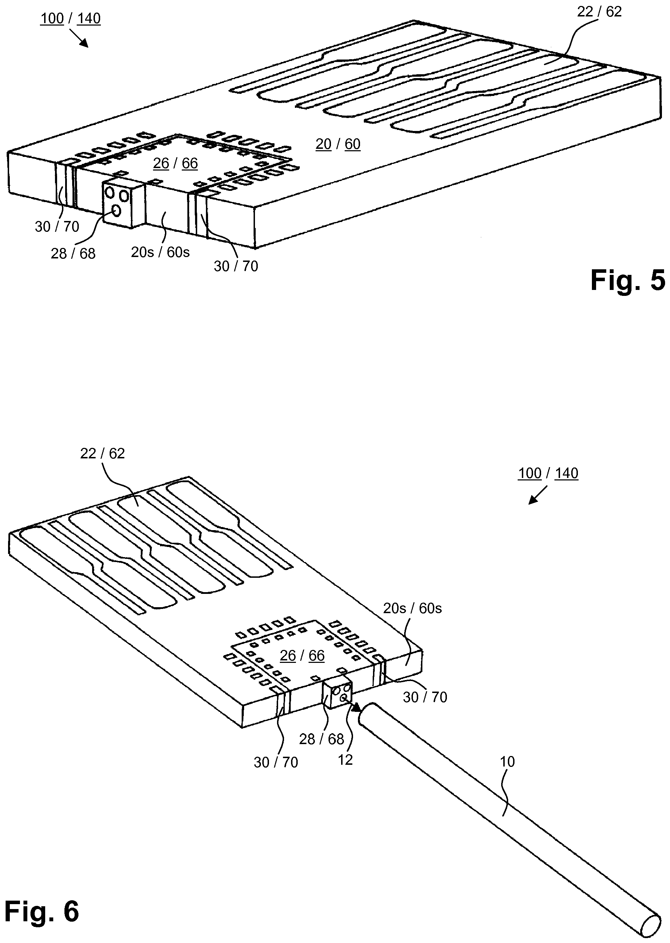

An der vom Substrat 20 bzw. 60 abgewandten Stirnseite 20s bzw. 60s des ASIC 26 bzw. 66 ist der elektro-optische Wandler 28 bzw. opto-elektrische Wandler 68 so angeordnet, dass die Sende- bzw. Empfangsrichtung dieses elektro-optischen Wandlers 28 bzw. opto-elektrischen Wandlers 68 im Wesentlichen senkrecht zur Stirnseite 20s bzw. 60s liegt (vgl. Fig. 5).

Der elektro-optische Wandler 28 bzw. opto-elektrische Wandler 68 zeigt also mit seiner optischen Öffnung in axialer Richtung 12 zum optischen Wellenleiter 10 (vgl. Fig. 6).

Wie Fig. 6 des Weiteren entnehmbar, sind an der Stirnseite 20s bzw. 60s des Substrats 20 bzw. 60 jeweils zwei Bondflächen 30 bzw. 70 zum Anschließen des elektro-optischen Wandlers 28 bzw. des opto-elektrischen Wandlers 68 angeordnet, insbesondere im Substrat 20 bzw. 60 eingearbeitet oder eingegossen.

Aus Fig. 7 geht hervor, dass der optische Wellenleiter 10 durch ein umschließendes Gehäuse 14 mechanisch am Substrat 20 bzw. 60 anordbar, insbesondere befestigbar ist. Hierbei kann es vorteilhaft sein, wenn innerhalb dieses Gehäuses 14 eine Führung für den Wellenleiter 10 eingearbeitet ist, die ein Ausrichten des Wellenleiters 10 zum elektro-optischen Wandler 28 bzw. opto-elektrischen Wandler 68 während des Zusammenfügens erleichtert. Diese Führung kann alternativ auch an der Vorrichtung selbst angebracht sein.

Im Unterschied zum Ausführungsbeispiel gemäß Fig. 4A bis Fig. 7 kann der zur Signalverarbeitung und -verstärkung vorgesehene ASIC 26 bzw. 66 auch komplett oder vollständig im Substrat 20 bzw. 60 eingebettet, insbesondere eingepasst, zum Beispiel eingeklebt, sein, wie aus Fig. 8 hervorgeht.

Hierbei ist die Höhe des ASIC 26 bzw. 66 etwas geringer als die Höhe des Substrats 20 bzw. 60, so dass der ASIC 26 bzw. 66 zwar im Wesentlichen in der Ebene des Substrats 20 bzw. 60, jedoch mit seiner Oberfläche leicht vertieft gegenüber der Oberfläche des Substrats 20 bzw. 60 in der Aussparung 24 bzw. 64 angeordnet ist.

Wenn die Höhe des ASIC 26 bzw. 66 im Wesentlichen gleich der Höhe des Substrats 20 bzw. 60 ist, so ist der ASIC 26 bzw. 66 in der Ebene des Substrats 20 bzw. 60 angeordnet.

Gemäß Fig. 8 ist die elektro-optische Sendeeinheit 28 bzw. opto-elektrische Empfangseinheit 68 an der Stirnseite 20s bzw. 60s des Substrats 20 bzw. 60 angeordnet, so dass die Sende- bzw. Empfangsrichtung 12 im Wesentlichen senkrecht zur Stirnfläche 20s bzw. 60s liegt und der Wandler 28 bzw. 68 gleichzeitig mit seiner optischen Öffnung in Richtung des optischen Wellenleiters 10 bzw. der optischen Faser zeigt.

In gegenüber Fig. 8 leicht abgewandelter Weise kann der elektro-optische Wandler 28 bzw. opto-elektrische Wandler 68 gemäß Fig. 9 in einer seiner Dimensionierung entsprechenden Ausnehmung 38 bzw. 78 an der Stirnseite 20s bzw. 60s des Substrats 20 bzw. 60 angeordnet sein.

Hierbei ist die Höhe des ASIC 26 bzw. 66 etwas geringer als die Höhe des Substrats 20 bzw. 60, so dass der ASIC 26 bzw. 66 zwar im Wesentlichen in der Ebene des Substrats 20 bzw. 60, jedoch mit seiner Oberfläche leicht vertieft gegenüber der Oberfläche des Substrats 20 bzw. 60 in der Aussparung 24 bzw. 64 angeordnet angeordnet ist.

Wenn die Höhe des ASIC 26 bzw. 66 im Wesentlichen gleich der Höhe des Substrats 20 bzw. 60 ist, so ist der ASIC 26 bzw. 66 in der Ebene des Substrats 20 bzw. 60 angeordnet.

Gemäß Fig. 9 ist die elektro-optische Sendeeinheit 28 bzw. opto-elektrische Empfangseinheit 68 so ausgerichtet, dass die Sende- bzw. Empfangsrichtung 12 im Wesentlichen senkrecht zur Stirnseite 20s bzw. 60s liegt und der Wandler 28 bzw. 68 gleichzeitig mit seiner optischen Öffnung in Richtung des optischen Wellenleiters 10 bzw. der optischen Faser zeigt.

In gegenüber Fig. 8 und gegenüber Fig. 9 leicht abgewandelter Weise kann der elektro-optische Wandler 28 bzw. opto-elektrische Wandler 68 gemäß Fig. 10 wie auch der ASIC 26 bzw. 66 komplett oder vollständig im Substrat 20 bzw. 60 eingebettet bzw. eingepasst sein.

Hierbei ist die Höhe des ASIC 26 bzw. 66 etwas geringer als die Höhe des Substrats 20 bzw. 60, so dass der ASIC 26 bzw. 66 zwar im Wesentlichen in der Ebene des Substrats 20 bzw. 60, jedoch mit seiner Oberfläche leicht vertieft gegenüber der Oberfläche des Substrats 20 bzw. 60 in der Aussparung 24 bzw. 64 angeordnet angeordnet ist.

Wenn die Höhe des ASIC 26 bzw. 66 im Wesentlichen gleich der Höhe des Substrats 20 bzw. 60 ist, so ist der ASIC 26 bzw. 66 in der Ebene des Substrats 20 bzw. 60 angeordnet.

Gemäß Fig. 10 ist der optische Ausgang der elektro-optischen Sendeeinheit 28 bzw. der optische Eingang der opto-elektrischen Empfangseinheit 68 mittels eines optischen Durchlasses 32 bzw. 72 in Form einer Bohrung oder eines optischen Substrats an der Stirnseite 20s bzw. 60s des Substrats 20 bzw. 60 erreichbar.

Die Öffnung 32 bzw. 72 an der Stirnseite 20s bzw. 60s des Substrats 20 bzw. 60 ist gemäß Fig. 10 so ausgerichtet, dass die Sende- bzw. Empfangsrichtung 12 dieses eingebetteten elektro-optischen Wandlers 28 bzw. opto-elektrischen Wandlers 68 im Wesentlichen senkrecht zur Stirnseite 20s bzw. 60s liegt, das heißt der Wandler 28 bzw. 68 mit seiner optischen Öffnung in Richtung 12 des optischen Wellenleiters 10 bzw. der optischen Faser zeigt.

### Bezugszeichenliste

- 10: Wellenleiter
- 12: axiale Richtung des Wellenleiters 10
- 14: Gehäuse
- 20: sendeseitiges Substrat, insbesondere sendeseitige Leiterplatte
- 20s: Stirnseite des sendeseitigen Substrats 20
- 22: sendeseitiger Anschlusskontakt
- 24: sendeseitige Aussparung zur Aufnahme des sendeseitigen Schaltkreises 26
- 26: sendeseitiger Schaltkreis, insbesondere sendeseitige anwendungsspezifische integrierte Schaltung oder sendeseitiger Application-Specific Integrated Circuit (ASIC), zum Beispiel sendeseitiger custom chip
- 28: elektro-optischer Wandler, insbesondere aktiv-optische Sendeeinheit
- 30: Bondflächen des elektro-optischen Wandlers 28
- 32: sendeseitiger optischer Durchlass
- 38: sendeseitige Ausnehmung zur Aufnahme des elektro-optischen Wandlers 28
- 60: empfangsseitiges Substrat, insbesondere empfangsseitige Leiterplatte
- 60s: Stirnseite des empfangsseitigen Substrats 60
- 62: empfangsseitiger Anschlusskontakt
- 64: empfangsseitige Aussparung zur Aufnahme des empfangsseitigen Schaltkreises 66
- 66: empfangsseitiger Schaltkreis, insbesondere empfangsseitige anwendungsspezifische integrierte Schaltung oder empfangsseitiger Application-Specific Integrated Circuit (ASIC), zum Beispiel empfangsseitiger custom chip
- 68: opto-elektrischer Wandler, insbesondere aktiv-optische Empfangseinheit
- 70: Bondflächen des opto-elektrischen Wandlers 68
- 72: empfangsseitiger optischer Durchlass
- 78: empfangsseitige Ausnehmung zur Aufnahme des opto-elektrischen Wandlers 68
- 100: sendeseitige Vorrichtung (= Ausführungsbeispiel; vgl. Fig. 4A bis Fig. 7)
- 100': sendeseitige Vorrichtung
- 100": sendeseitige Vorrichtung
- 100'": sendeseitige Vorrichtung
- 140: empfangsseitige Vorrichtung (= Ausführungsbeispiel; vgl. Fig. 4A bis Fig. 7)
- 140': empfangsseitige Vorrichtung
- 140": empfangsseitige Vorrichtung
- 140'": empfangsseitige Vorrichtung
- ASIC: Schaltkreis, insbesondere anwendungsspezifische integrierte Schaltung oder Application-Specific Integrated Circuit (ASIC), zum Beispiel custom chip (= Stand der Technik; vgl. Fig. 1 und Fig. 2)
- HA: Halterung (= Stand der Technik; vgl. Fig. 2)
- SI: optisches Signal (= Stand der Technik; vgl. Fig. 1 und Fig. 2)
- US: Umlenkspiegel (= Stand der Technik; vgl. Fig. 1)
- WA: optischer Wandler (= Stand der Technik; vgl. Fig. 1 und Fig. 2)
- WL: optischer Wellenleiter (= Stand der Technik; vgl. Fig. 1 und Fig. 2)

## Patentansprüche

1. Vorrichtung (100) zum Einkoppeln optischer Signale in mindestens einen Wellenleiter (10), welche Vorrichtung (100) mindestens einen sendeseitigen Schaltkreis (26) aufweist, der auf Basis von von sendeseitigen Anschlusskontakten (22) eingehenden Signalen mindestens einen elektro-optischen Wandler (28) ansteuert, der die optischen Signale in Richtung der Achse (12) des Wellenleiters (10) aussendet,
wobei der sendeseitige Schaltkreis (26) im Wesentlichen in der Ebene eines die sendeseitigen Anschlusskontakte (22) aufweisenden sendeseitigen Substrats (20) angeordnet ist,
wobei das Substrat (20) eine Aussparung (24) zur Aufnahme des Schaltkreises (26) aufweist,
**dadurch gekennzeichnet,**
- **dass** die Höhe des Schaltkreises (26) im Wesentlichen gleich der Höhe des Substrats (20) ist,
- **dass** an der Stirnseite (20s) des Substrats (20) und/oder des Schaltkreises (26) mindestens eine Bondfläche (30) zum Anschließen des Wandlers (28) angeordnet ist,
- **dass** die Aussparung (24) zur Stirnseite (20s) des Substrats (20) hin offen und so dimensioniert ist, dass der Schaltkreis (26) im Wesentlichen bündig mit der Stirnseite (20s) abschließt, und
- **dass** der Wandler (28) an der vom Substrat (20) abgewandten Stirnseite (20s) des Schaltkreises (26) so angeordnet ist, dass die Senderichtung des Wandlers (28) im Wesentlichen senkrecht zur Stirnseite (20s) des Schaltkreises (26) liegt.

2. Vorrichtung (140) zum Auskoppeln optischer Signale aus mindestens einem Wellenleiter (10) in mindestens einen opto-elektischen Wandler (68), der die optischen Signale aus Richtung der Achse (12) des Wellenleiters (10) aufnimmt und als elektrische Signale an mindestens einen empfangsseitigen Schaltkreis (66) übermittelt, der die eingehenden elektrischen Signale verarbeitet und an empfangsseitige Anschlusskontakte (62) ausgibt,
wobei der empfangsseitige Schaltkreis (66) im Wesentlichen in der Ebene eines die empfangsseitigen Anschlusskontakte (62) aufweisenden empfangsseitigen Substrats (60) angeordnet ist,
wobei das Substrat (60) eine Aussparung (64) zur Aufnahme des Schaltkreises (66) aufweist,
**dadurch gekennzeichnet,**
- **dass** die Höhe des Schaltkreises (66) im Wesentlichen gleich der Höhe des Substrats (60) ist,
- **dass** an der Stirnseite (60s) des Substrats (60) und/oder des Schaltkreises (66) mindestens eine Bondfläche (70) zum Anschließen des Wandlers (68) angeordnet ist,
- **dass** die Aussparung (64) zur Stirnseite (60s) des Substrats (60) hin offen und so dimensioniert ist, dass der Schaltkreis (66) im Wesentlichen bündig mit der Stirnseite (60s) abschließt, und
- **dass** der Wandler (68) an der vom Substrat (60) abgewandten Stirnseite (60s) des Schaltkreises (66) so angeordnet ist, dass die Empfangsrichtung des Wandlers (68) im Wesentlichen senkrecht zur Stirnseite (60s) des Schaltkreises (66) liegt.

3. Vorrichtung gemäß Anspruch 1 oder 2, **dadurch gekennzeichnet, dass** der Wandler (28; 68) nicht bündig mit der Stirnseite (20s; 60s) des Substrats (20; 60) und/oder des Schaltkreises (26; 66) abschließt.

4. Vorrichtung gemäß mindestens einem der Ansprüche 1 bis 3, **dadurch gekennzeichnet, dass** der Wellenleiter (10) mittels eines, insbesondere umschließenden, Gehäuses (14) dem Wandler (28; 68) zuordbar ist.

5. Vorrichtung gemäß Anspruch 4, **dadurch gekennzeichnet, dass** innerhalb des Gehäuses (14) und/oder an der Vorrichtung (100; 140) mindestens eine Führung zum Ausrichten des Wellenleiters (10) bezüglich des Wandlers (28; 68) angeordnet ist.

6. Vorrichtung gemäß mindestens einem der Ansprüche 1 bis 5, **dadurch gekennzeichnet,**
- **dass** der elektro-optische Wandler (28) mindestens ein Laser, insbesondere mindestens ein Vertical Cavity Surface Emitting Laser (VCSEL), ist und/oder
- **dass** der opto-elektrische Wandler (68) mindestens eine Diode, insbesondere mindestens eine Fotodiode, ist und/oder
- **dass** der Schaltkreis (26; 66) mindestens eine anwendungsspezifische integrierte Schaltung oder mindestens ein Application-Specific Integrated Circuit (ASIC), insbesondere mindestens ein custom chip, ist.

7. Verwendung mindestens einer Vorrichtung (100; 140) gemäß mindestens einem der Ansprüche 1 bis 6 zum Aufbau mindestens eines, insbesondere steckbaren, aktiven optischen Kabels.

## Claims

1. A device (100) for incoupling optical signals into at least one waveguide (10), said device (100) comprising at least one send-site circuit (26) which based on incoming signals from send-site terminal contacts (22) actuates at least one electro-optical converter (28) which sends out the optical signals in the direction of the axis (12) of the waveguide (10),
wherein the send-site circuit (26) is arranged essentially in the plane of a send-site substrate (20) comprising the send-site terminal contacts (22),
wherein the substrate (20) comprises a notch (24) for incorporating the circuit (26),
**characterized in**
- **that** the height of the circuit (26) is essentially equal to the height of the substrate (20),
- **that** at least one bonding surface (30) for connecting the converter (28) is arranged on the front face (20s) of the substrate (20) and/or of the circuit (26),
- **that** the notch (24) is open toward the front face (20s) of the substrate (20), and dimensioned in such way that the circuit (26) abuts essentially flush against the front face (20s), and
- **that** the converter (28) is arranged on the circuit's (26) front face (20s) facing away from the substrate (20) in such way that the sending direction of the converter (28) lies essentially perpendicular to the front face (20s) of the circuit (26).

2. A device (140) for outcoupling optical signals from at least one waveguide (10) into at least one opto-electrical converter (68) which receives the optical signals from the direction of the axis (12) of the waveguide (10), and transmits them as electrical signals to at least one receive-site circuit (66), which processes the incoming electrical signals and outputs them to receive-site terminal contacts (62),
wherein the receive-site circuit (66) is arranged essentially in the plane of a receive-site substrate (60) comprising the receive-site terminal contacts (62),
wherein the substrate (60) comprises a notch (64) for incorporating the circuit (66),
**characterized in**
- **that** the height of the circuit (66) is essentially equal to the height of the substrate (60),
- **that** at least one bonding surface (70) for connecting the converter (68) is arranged on the front face (60s) of the substrate (60) and/or of the circuit (66),
- **that** the notch (64) is open toward the front face (60s) of the substrate (60), and dimensioned in such way that the circuit (66) abuts essentially flush against the front face (60s), and
- **that** the converter (68) is arranged on the circuit's (66) front face (60s) facing away from the substrate (60) in such way that the receiving direction of the converter (68) lies essentially perpendicular to the front face (60s) of the circuit (66).

3. The device according to claim 1 or 2, **characterized in that** the converter (28; 68) does not abut flush against the front face (20s; 60s) of the substrate (20; 60) and/or of the circuit (26; 66).

4. The device according to at least one of claims 1 to 3, **characterized in that** the waveguide (10) is assignable to the converter (28; 68) by means of an, in particular enclosing, housing (14).

5. The device according to claim 4, **characterized in that** at least one guide for aligning the waveguide (10) relative to the converter(28; 68) is arranged inside the housing (14) and/or on the device (100; 140).

6. The device according to at least one of claims 1 to 5, **characterized in**
- **that** the electro-optical converter (28) is at least one laser, in particular at least one vertical cavity surface emitting laser (VCSEL), and/or
- **that** opto-electrical converter (68) is at least one diode, in particular at least one photo diode, and/or
- **that** the circuit (26; 66) is at least one application-specific integrated circuit (ASIC), in particular at least one custom chip.

7. Use of at least one device (100; 140) according to at least one of claims 1 to 6 for forming at least one, in particular pluggable, active optical cable.

## Revendications

1. Dispositif (100) pour coupler des signaux optiques dans au moins un guide d'ondes (10), lequel dispositif (100) comporte au moins un circuit côté émission (26), qui contrôle au moins un convertisseur électro-optique (28) sur la base de signaux provenant de contacts de raccordement côté émission (22), lequel convertisseur électro-optique (28) émettant les signaux optiques dans la direction de l'axe (12) du guide d'ondes (10),
le circuit côté émission (26) étant disposé sensiblement dans le plan d'un substrat côté émission (20) comportant les contacts de raccordement côté émission (22),
le substrat (20) comportant un évidement (24) pour accueillir le circuit (26),
**caractérisé en ce**
- **que** la hauteur du circuit (26) est sensiblement égale à la hauteur du substrat (20),
- **qu'**au moins une surface de liaison (30) pour la connexion du convertisseur (28) est disposée sur la face avant (20s) du substrat (20) et/ou du circuit (26),
- **que** l'évidement (24) est ouvert vers la face avant (20s) du substrat (20) et dimensionné de telle manière que le circuit (26) se termine essentiellement au ras de la face avant (20s), et
- **que** le convertisseur (28) est disposé sur la face avant (20s) du circuit (26) évitée du substrat (20) de telle manière que la direction d'émission du convertisseur (28) soit essentiellement perpendiculaire à la face avant (20s) du circuit (26).

2. Dispositif (140) pour coupler des signaux optiques provenant d'au moins un guide d'ondes (10) dans au moins un convertisseur opto-électrique (68), lequel dispositif (140) recevant les signaux optiques de la direction de l'axe (12) du guide d'ondes (10) et transmettant ces signaux optiques comme signaux électriques à au moins un circuit côté réception (66), qui traite les signaux électriques entrants et les transmet à des contacts de raccordement côté réception (62),
le circuit côté réception (66) étant disposé sensiblement dans le plan d'un substrat côté réception (60) comportant les contacts de raccordement côté réception (62),
le substrat (60) comportant un évidement (64) pour accueillir le circuit (66),
**caractérisé en ce**
- **que** la hauteur du circuit (66) est sensiblement égale à la hauteur du substrat (60),
- **qu'**au moins une surface de liaison (70) pour la connexion du convertisseur (68) est disposée sur la face avant (60s) du substrat (60) et/ou du circuit (66),
- **que** l'évidement (64) est ouvert vers la face avant (60s) du substrat (60) et dimensionné de telle manière que le circuit (66) se termine essentiellement au ras de la face avant (60s), et
- **que** le convertisseur (68) est disposé sur la face avant (60s) du circuit (66) évitée du substrat (60) de telle manière que la direction de réception du convertisseur (68) soit essentiellement perpendiculaire à la face avant (60s) du circuit (66).

3. Dispositif selon la revendication 1 ou 2, **caractérisé en ce que** le convertisseur (28 ; 68) ne se termine pas au ras de la face avant (20s ; 60s) du substrat (20 ; 60) et/ou du circuit (26 ; 66).

4. Dispositif selon au moins l'une des revendications 1 à 3, **caractérisé en ce que** le guide d'ondes (10) est assignable au convertisseur (28 ; 68) au moyen d'un boîtier (14), en particulier englobant.

5. Dispositif selon la revendication 4, **caractérisé en ce qu'**au moins un guide pour l'alignement du guide d'ondes (10) par rapport au convertisseur (28 ; 68) est disposé à l'intérieur du boîtier (14) et/ou sur le dispositif (100 ; 140).

6. Dispositif selon au moins l'une des revendications 1 à 5, **caractérisé en ce**
- **que** le convertisseur électro-optique (28) est au moins un laser, en particulier au moins un laser à émission de surface à cavité verticale (VCSEL), et/ou
- **que** le convertisseur opto-électrique (68) est au moins une diode, en particulier au moins une photodiode, et/ou
- **que** le circuit (26 ; 66) est au moins un circuit intégré spécifique à une application (ASIC), en particulier au moins un custom chip.

7. Utilisation d'au moins un dispositif (100 ; 140) selon au moins l'une des revendications 1 à 6 pour la construction d'au moins un câble optique actif, en particulier enfichable.
